# EUROPEAN PATENT APPLICATION

(11) **EP 4 343 812 A1**
(43) Date of publication of application: **27.03.2024**
(21) Application number: 22197831.5
(22) Date of filing: 26.09.2022
(51) Int. Cl.: H01J 37/244, H01J 37/28

(54) **DATA PROCESSING DEVICE AND METHOD, CHARGED PARTICLE ASSESSMENT SYSTEM AND METHOD**

(71) Applicant: ASML Netherlands B.V., 5500 AH Veldhoven (NL)
(72) Inventor: WIELAND, Marco, Jan-Jaco, 5500 AH Veldhoven (NL)
(74) Representative: ASML Netherlands B.V.

(57) **Abstract**

A charged particle assessment apparatus for detecting defects in samples by scanning a charged particle beam across a sample; the apparatus comprising:
a detector unit configured to output a digital detection signal of pixel values in response to signal particles incident from the sample, the pixel values representing elongate pixels.

## Description

### FIELD

The embodiments provided herein generally relate to data processing devices and methods, especially for use with or in charged particle assessment systems and methods of operating charged particle assessment systems.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection apparatuses with a charged particle beam have been used to inspect objects, which may be referred to as samples, for example to detect pattern defects. These apparatuses typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection apparatus may obtain an image representing characteristics of the material structure of the surface of the sample.

When a pattern inspection apparatus is used to detect defects on samples at a high throughput, a very large amount of image data is generated and must be processed to detect defects. In particular it is desirable to reduce noise from image data. US 8,712,184 B1 and US 9,436,985 B1 describe methods of reducing noise or improving signal-to-noise ratio in images obtained from scanning electron microscopes. In some cases, the rate of data generation can be an undesirable limit on the throughput of a pattern inspection apparatus, e.g. because the transmission rate from the detector to data processing equipment is limited.

### SUMMARY

It is an object of the present disclosure to provide embodiments that avoid or ameliorate data transmission limits on the throughput of charged particle assessment apparatus used to detect defects.

According to a first aspect of the invention, there is provided a charged particle assessment apparatus for detecting defects in samples by scanning a charged particle beam across a sample; the apparatus comprising: a detector unit configured to output a digital detection signal of pixel values in response to signal particles incident from the sample, the pixel values representing elongate pixels.

According to a second aspect of the invention, there is provided an image analysis device comprising: an input module or interface module configured to receive sample image data comprising pixel values representing an image of a sample obtained by a charged particle assessment device, wherein each pixel value represents a pixel that is elongate; and a de-noising module or downstream filter configured to apply a de-noising filter to generate a filtered signal.

According to a third aspect of the invention, there is provided a charged particle assessment system comprising: a charged particle assessment apparatus according to the first aspect of the invention; an image analysis device according to the second aspect of the invention; and a communication channel configured to communicate the series of pixel values from the charged particle assessment device to the image analysis device.

According to a fourth aspect of the invention, there is provided a computer readable storage medium storing sample image data comprising pixel values representing an image of a sample obtained by a charged particle assessment system, wherein each pixel value represents a pixel that is elongate, desirably each pixel value having a contrast value representing a contrast in a contrast range, wherein the relative contrasts of adjacent elongate pixels exceeding a contrast different being indicative of a defect, desirably the pixel values are configured to be renderable as pixels for example, in an image, arranged in a two dimensional array, desirably the two dimensional array is a grid, the pixels desirably having unequal dimensions, desirably being rectangular.

According to a fifth aspect of the invention, there is provided an image of a surface of a sample for detecting defects in the sample, the image comprising a plurality of elongate pixels each representing a portion of the sample surface and each having a different contrast, wherein the relative contrast of the elongate pixels being indicative of a defect, desirably the elongate pixels arranged in a two dimensional array, desirably the two dimensional array is a grid, the elongate pixels desirably being having unequal dimensions, desirably being rectangular.

According to a sixth aspect of the invention, there is provided a method of data processing for an array mode using at least an image of a surface of a sample having a repeating pattern, the method comprising: generating at least one image of a surface of a sample having a repeating pattern, e.g. using/in a detector unit, the image having elongate pixels having an elongate direction and a reduced direction; and aligning at least portions of the at least one image with respect to a repeating period of the pattern, to be equal to a whole number of pixels in the elongate direction or a whole number of pixels in the reduced direction; wherein the aligning comprises changing the aspect ratio of the pixels.

According to a seventh aspect of the invention, there is provided a method of data processing for a die to database mode for comparing a detection data with reference data, comprising: generating detection data map of a sample surface, e.g. using a detector unit, the detection data having elongate detected pixels with an elongate direction and a reduced direction: shifting reference data to form a reference data map corresponding to the detection data map; and processing the reference data map comprising combining pixels of the reference data map in the longitudinal direction of the elongate detected pixels to derive a processed reference data map, the processed reference data map having the same size of pixel as the elongate detected pixels and the processed reference data map configured to have the same further processing applied as the detection data map.

According to an eighth aspect of the invention, there is provided an image analysis method comprising: receiving sample image data comprising pixel values representing an image of a sample obtained by a charged particle assessment method, wherein each pixel value represents a pixel that is elongate; applying a de-noising filter to generate a filtered signal.

According to a ninth aspect of the invention, there is provided an image analysis method as described above wherein the reference data comprises reference pixel data that is higher resolution than the sample image data and the comparing comprises: aligning the reference pixel data to the sample image data and generate aligned reference pixel data; and down-sampling the aligned reference pixel data to generate down-sampling reference pixel data having the same resolution as the sample image data; and comparing pixel data of the sample image data to corresponding down-sampled reference pixel data.

According to a tenth aspect of the invention, there is provided a detector unit for a charged particle assessment apparatus for detecting defects in samples by scanning a charged particle beam across a sample, the detector unit configured to output a digital detection signal of pixel values in response to signal particles incident from a sample, the pixel values representing elongate pixels.

According to an eleventh aspect of the invention, there is provided a detector unit for a charged particle assessment apparatus for detecting defects in samples by scanning a charged particle beam across a sample and outputting a detection signal of pixel values representing elongate pixels, the detector unit comprising a detector element to generate a detector signal in response to incident charged particles; and an integrator configured to filter the detector signal to generate an integrated detection signal, wherein the integrator is configured to filter the detector signal in an elongate direction corresponding to an elongate dimension of the pixel.

According to a twelfth aspect of the invention, there is provided a detector unit for a charged particle assessment apparatus for detecting defects in samples by scanning a charged particle beam across a sample, the detector unit configured to output a digital detection signal of pixel values in response to signal particles incident from a sample, the detector unit, comprising:
a detector element configured to generate a detector signal in response to incident charged particles; and
a trans-impedance amplifier with a capacitive feedback configured to amplify the detector signal.

According to a thirteenth aspect of the invention, there is provided a charged particle assessment apparatus for detecting defects in samples by scanning a charged particle beam across a sample; the apparatus comprising:
a charged particle device configured to direct a charged particle beam toward a sample;
a detector unit configured to output a digital detection signal of pixel values in response to signal particles incident from the sample, the pixel values representing elongate pixels having a longitudinal direction and a transverse direction; and
a stage configured to support a sample; wherein:
   the charged particle device and the stage are configured to scan a surface of the sample with the charged particle beam;
   the stage is configured to move in a sub-scanning direction when the surface of the sample is scanned with the charged particle beam, the sub-scanning direction corresponding to the transverse direction.

According to a fourteenth aspect of the invention, there is provided a charged particle assessment apparatus for detecting defects in samples by scanning a charged particle beam across a sample; the apparatus comprising:
a charged particle device configured to direct a charged particle beam toward a sample, desirably the charged particle device comprising a deflector;
a detector unit configured to output a digital detection signal of pixel values in response to signal particles incident from the sample, the pixel values representing elongate pixels having a longitudinal direction and a transverse direction; and
a stage configured to support a sample, the charged particle device and the stage being configured to scan a surface of the sample with the charged particle beam; wherein:
   the charged particle device (desirably the deflector) is configured to direct the beam in a main scanning direction when the surface of the sample is scanned with the charged particle beam, the main scanning direction corresponding to the longitudinal direction, and/or in a sub-scanning direction corresponding to the transverse direction, desirably the main scanning direction has a different orientation from the sub-scanning direction.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection system.
**FIG. 2** is a schematic diagram illustrating an exemplary multi-beam charged particle assessment apparatus that is part of the exemplary charged particle beam inspection system of **FIG. 1****.**
**FIG. 3** is a schematic diagram illustrating an exemplary arrangement for transmitting data from a detector module to an external data processing apparatus
**FIG. 4** is a schematic diagram of a data path according to an embodiment.
**FIG. 5** is a diagram of a uniform kernel an embodiment.
**FIG. 6** is a diagram illustrating the relationship between a defect, a measurement spot and image pixels in a conventional arrangement.
**FIG. 7** is a diagram illustrating the relationship between a defect, a measurement spot and image pixels in an embodiment.
**FIG. 8** is a schematic diagram of circuitry in an electron-optical columns, e.g. in a detector module, in an embodiment.
**FIG. 9** is a schematic diagram of a filter in an embodiment.
**FIG. 10** is a schematic diagram of an image analysis system of an embodiment.
**FIG. 11** is a schematic diagram of a comparator of an embodiment.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection devices (such as a Scanning Electron Microscope ('SEM')) is essential for maintaining high yield and low cost.

An embodiment of a SEM comprises a scanning device and a detector apparatus. The scanning device comprises an illumination apparatus that comprises an electron source, for generating primary electrons (or charged particles), and a projection apparatus for scanning a sample, such as a substrate, with one or more focused beams (or a plurality of beams) of primary electrons. The plurality of beams may be arranged as a multi-beam. The plurality of beams may have a multi-beam arrangement (which may have the form of a grid) which may be directed along a multi-beam path towards a sample. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

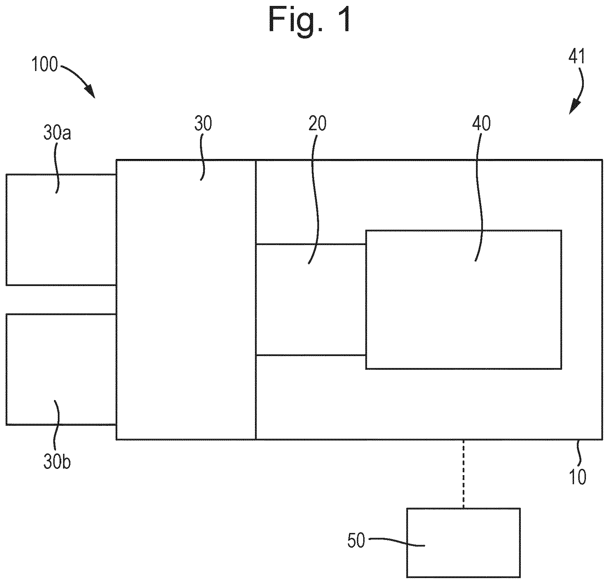

Reference is now made to FIG. 1, which is a schematic diagram illustrating an exemplary charged particle beam assessment system 100 (or simply an assessment system), which may also be referred to as a charged particle beam inspection system or simply inspection system or a charged particle metrology system or simply a metrology system. The charged particle beam assessment system 100 of FIG. 1 includes a main chamber 10 (e.g. a vacuum chamber), a load lock chamber 20, an electron beam system 40, an equipment front end module (EFEM) 30 and a controller 50. The electron beam system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam system by which it may be inspected. An electron beam system 40 may comprise a multi-beam electron-optical apparatus (which may be referred to an electron-optical column or device).

The controller 50 is electronically connected to electron beam system 40. The controller 50 may be a processor (such as a computer) configured to control the charged particle beam assessment apparatus 100. The controller 50 may also include circuitry which may be referred to as processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam system, it should be noted that aspects of the disclosure in their broadest sense are not limited to a chamber housing an electron beam system. Rather, it is appreciated that the foregoing principles may also be applied to other devices, and other arrangements of apparatus, that operate under the second pressure. For example the controller may be a distributed controller having one or more parts at the second pressure, optionally with one more parts at the first pressure.

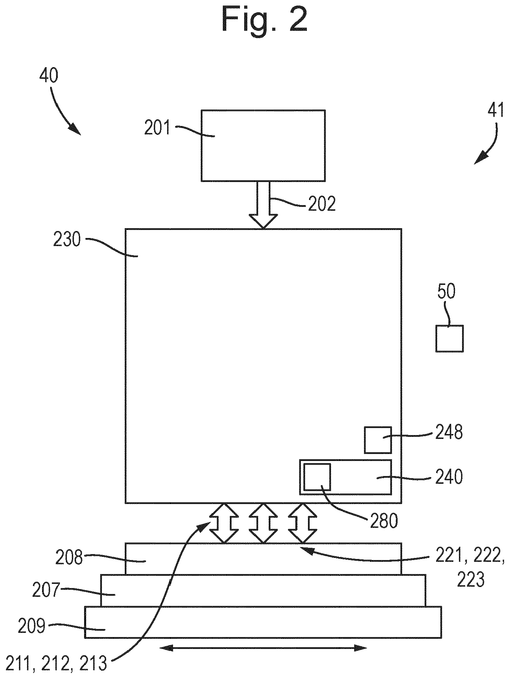

Reference is now made to **FIG. 2****,** which is a schematic diagram illustrating an exemplary electron beam system 40, including a multi-beam electron-optical system 41, that is part of the exemplary charged particle beam assessment apparatus 100 of **FIG. 1****.** The electron beam system 40 comprises an electron source 201 and a projection apparatus 230. The electron beam system 40 further comprises an actuated stage 209 and a sample holder 207. The electron source 201 and projection apparatus 230 may together be referred to as the electron-optical system 41 or as an electron-optical column. The sample holder 207 is supported by actuated stage 209 so as to hold a sample 208 (e.g., a substrate or a mask) for inspection. The multi-beam electron-optical system 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds, many thousands for example approximately ten thousand, many tens of thousands or many hundreds of thousands of sub-beams. The sub-beams may be referred to as beamlets.

The controller 50 may be connected to various parts of the charged particle beam assessment apparatus 100 of **FIG. 1****,** such as the electron source 201, the detector 240, the projection apparatus 230, and the actuated stage 209 (e.g. a motorized stage). The controller 50 may perform various image and signal processing functions. The controller 50 may also generate various control signals to govern operations of the charged particle beam inspection apparatus, including the charged particle multi-beam apparatus.

The electron-optical apparatus 230 may be configured to focus sub-beams 211, 212, and 213 onto a sample 208 for inspection and may form probe spots 221, 222, and 223 (for this example three probe spots, one for each sub-beam) on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons which may be referred to as signal particles. The secondary electrons typically have electron energy less than or equal to 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV are generally treated as secondary electrons, a proportion of the actual backscatter electrons will be counted as secondary electrons.

The detector 240 is configured to detect signal particles such as secondary electrons and/or backscattered electrons and to generate corresponding signals which are sent to a signal processing system 280 for pre-processing, e.g. analog to digital conversion. The detector 240 may be incorporated into the projection apparatus 230. Further details and alternative arrangements of a detector module, sensor and detector array positioned proximate to, up beam, down beam or otherwise integrated into an objective lens can be found in EP Application Number 20216890.2 and PCT Application number PCT/EP2021/068548, which documents are respectively hereby incorporated by reference at least so far as they disclose details of the detector module, sensor and detector array and similar elements.

The detector may be provided with multiple portions and more specifically, multiple detecting portions. The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. The multiple portions may be segments are arranged radially and/or angularly. More specifically, the detector comprising multiple portions may be arranged around a single aperture, which provides an example of such a detector. As mentioned the detection signal from the detector module is used to generate an image. With multiple detecting portions, the detection signal comprises components from the different detecting signals that may be processed as data sets or in a detection image.

The objective lens may an objective lens array and may comprise a plurality of planar electrodes or plates comprising apertures for the respective paths of the beams of the multi-beam. Each plate may extend across the multibeam arrangement. The objective lens may comprise at least two electrodes that may be connected to and controlled respective potentials. There may be additional plates each to control an additional degree of freedom. The detector may be a plate associated with or connected to the objective lens with an aperture for each path of a beam of the multi-beam. The detector may be located above, below or within the objective lens.

A scan deflector may be associated or even integrated into the objective lens for example as an array of scan deflectors. An array of scan deflectors (e.g. an array of deflector elements) may be referred to as a deflector array. Each sub-beam may be associated with a deflector element of the deflector array In an arrangement the scan deflector may be positioned up beam of the object lens. In an arrangement in which the path of the primary beams are collimated up beam of the objective lens, the scan deflectors may be positioned up beam of the objective lens. In an arrangement in which the multibeam is generated from a collimated primary beam from a source by a beam limiting aperture array of or associated with the objective lens, the scan deflector may be a macro scan deflector positioned up beam of the objective lens and so as to operate on the collimated primary beam. Other electron-optical arrangements may be envisaged comprising one or more elements herein described. Such scan deflectors may be controlled by the controller to deflect the beams of the multi-beam along one axis in the plane of the sample or both primary axes over the surface of a sample e.g. in the plane of the sample (which may be orthogonal with respect to each other).

It should be noted that embodiments of scan deflectors that are proximate to the sample, for example integrated or proximate to the objective lens, may have a limited range of scan deflection. However scan deflectors proximate to the sample may be accurately controlled and have a fast response relative to other types of scanning actuators such as an actuated stage.

The controller 50 may control the actuated stage 209 to move sample 208 during inspection of the sample 208. The controller 50 may enable the actuated stage 209 to move the sample 208 in a direction, preferably continuously, for example at a constant speed, at least during sample inspection, which may be referred to as a type of scanning. The controller 50 may control movement of the actuated stage 209 so that it changes the speed of the movement of the sample 208 relative to the path of the multi-beam dependent on various parameters. The controller 50 may control deflection of the scan deflectors so that the path of the multibeam moves relative to the stage and thus over the sample surface. The controller 50 may change a beam deflection of the scan deflector and thus the scanning of the beams over the sample surface dependent on various parameters. For example, the controller 50 may control the stage speed (including its direction) and/or scan deflector depending on the characteristics of the inspection scanning elements and steps, for example in the scanning process and/or scans of the scanning process as disclosed in EPA 21171877.0 filed 3 May 2021. The content of such application is hereby incorporated in so far as it discloses a combined stepping and scanning strategy at least of the stage and scanning deflectors.

Known multi-beam systems, such as the electron beam system 40 and charged particle beam assessment apparatus 100 described above, are disclosed in US2020/118784, US202002/03116, US2019/0259564 and WO2021078352 which are hereby incorporated by reference.

The electron beam system 40 may comprise a projection assembly to regulate accumulated charges on the sample by illuminating the sample 208.

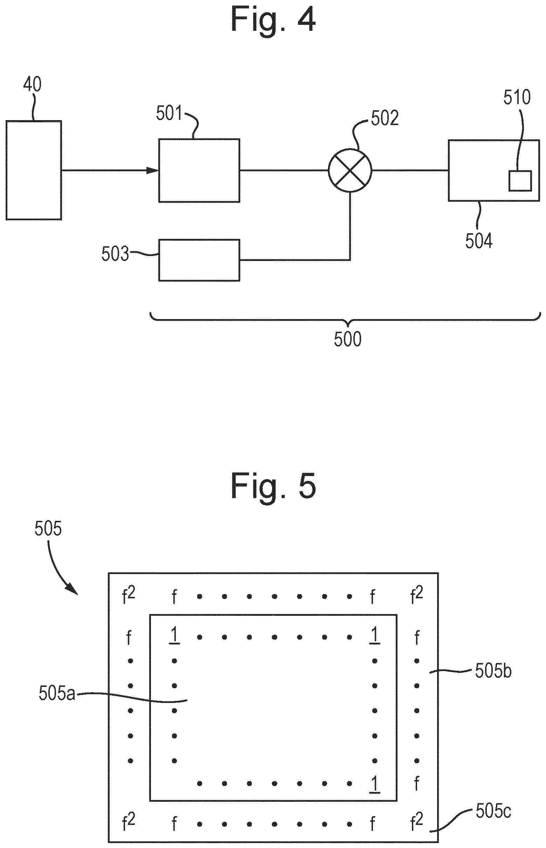

Images output from a charged particle assessment device, e.g. electron beam system 40 need to be processed automatically to detect defects in samples being assessed. A data processing device 500 for detecting defects in images generated by a charged particle assessment device is depicted in **FIG. 4****.** Data processing device 500, or at least a part of the data processing device 500, may be part of controller 50, part of another computer in the fab or integrated elsewhere in the charged particle assessment device.

In a charged particle inspection system, the or each electron-optical system 41 is located within main (vacuum) chamber 10. It is therefore necessary to transmit data from the electron-optical system(s) to devices outside the vacuum chamber such as data processing device 500. Raw data generated by the electron optical system(s) can be transmitted out of the vacuum chamber via signal conduits. Considering the quantity of data, the data may be optically transmitted, for example using optically capable signal conduits such as optic fibres. An optical transceiver is used to convert the electrical signals representative to the data to optical signals. The optical transceiver is located near the detector module 240 of the electron optical system 41. The optical transceiver is configured to convert the electrical signals output by the detector module 240 to optical signals for transmission along an optical fiber. The optical fiber may be capable of transmitting multiple channels simultaneously (e.g. using different wavelengths). Thus the detection signals from each individual electrode of the detector module are converted into an appropriate number of data streams. Multiple optical fibers, either as single channel or multi-channel optic fibers, can be used.

The or each signal conduit, e.g. optical fiber, passes through the wall of main chamber 10 (inside of which is at vacuum in use) by a vacuum feedthrough 11. A suitable vacuum feedthrough is described in US2018/0182514 A1 which document is incorporated herein by reference at least insofar as it relates to a feedthrough device. The signal conduit, e.g. optical fiber, is connected to data processing device 500, which can therefore be located outside the vacuum for ease of access and to avoid needing to increase the size of the vacuum chamber to accommodate the data processing device. In both single-column and multi-column systems, multiple optical transceivers and multiple optical fibers per column may be used if convenient.

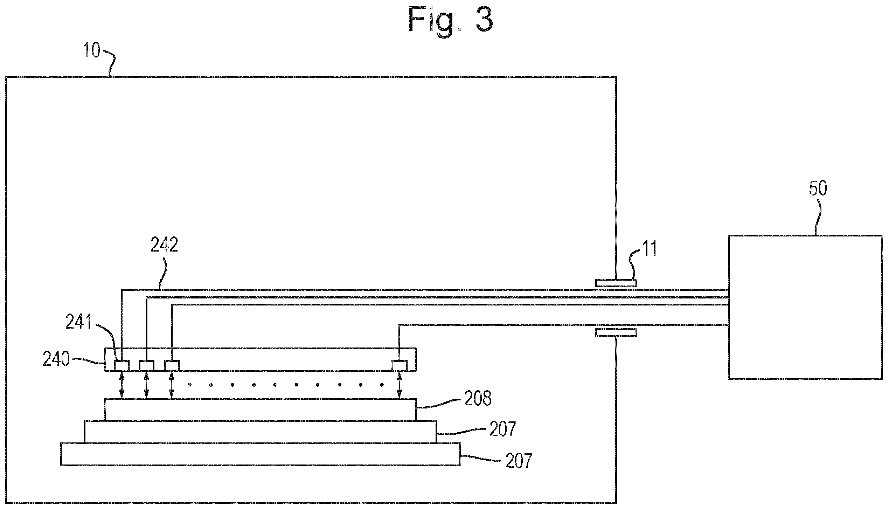

An arrangement involving multiple optical fibers (or other communication channels) is shown in **FIG. 3****.** Each optical fiber 242 is connected to a sub-unit (or detector unit) 241 of the detector module 240 and transmits signals generated by the respective sub-unit 241 to the data processing device 500 which is external to the main chamber 10. Each sub-unit 241 may include one or more individual electrodes of the detector module 240. It will be seen that in a multi-column system that is capable of imaging a large portion of the sample 208 at a time, there will need to be a large number of optical fibers 242 and hence vacuum feedthrough 11 must be large. As well as taking up space, a large vacuum feedthrough, or multiple smaller feedthroughs, can be difficult to seal.

It should be noted that a detector module, or detector array for an arrangement comprising a plurality of planar electron-optical elements, e.g. electrodes, placed along the multi-beam path, may have internal circuitry. The internal circuitry may comprise part or all of the processing circuitry, e.g. a CMOS structure, for connecting the individual detector elements, or detector units, in the detector array. In an alternative arrangement, two or more of the signal conduits for different detector units, may have a common or adjacent connection in the surface of the detector module. Co-locating a plurality of connections for signal conduits to the detector module simplifies connection of the signal conduits and the detector module to each other. In an arrangement multiple detector units have a common signal conduit, so multiple detector units may be grouped. Each detector unit may be associated with a beam of a multi-beam, such that a detector is arranged to detect signal particles from the sample generated by a specific beam of the plurality of beams. In a different arrangement an array of detector units each associated with a different pixel may be associated with a beam of the plurality of beams. Such an arrangement may be suited to an inspection system for finding detects. Such an arrangement may be suited to a metrology system where each pixel, e.g. a detector unit, is for counting signal electrons.

Various approaches may be taken to detect defects in images generated by a charged particle assessment device. A common approach is to compare an image of a part of the sample, referred to herein as a sample image, to a reference image. In practice, data points of a datastream representing the sample image are compared to data points of the reference image retrieved from a memory or delivered in a parallel datastream. For the sake of brevity, this process may be referred to below as comparing images and the data points as pixels. Any pixel that differs from the corresponding pixel of the reference image by more than a threshold amount may be considered a defect. Such a pixel that differs from the reference image, together with adjacent pixels that also differ from the reference image, is considered a single defect. (In an embodiment this may mean a pixel differing from the reference image and which has adjacent pixels which are the same as the reference image (i.e. do not differ from the reference image) can be considered to not represent a defect). The reference image may be obtained in various different ways, as discussed below. (Note: the data of the sample image may be referred to as sample image data; the data of the reference image (or reference data) may at least comprise, or even be referred to, as reference pixel data. The reference data may take the form of a reference data map).

The rate of false positives, i.e. samples labelled as having defects when in fact no significant defect is present, can be controlled. The rate of false positives can be controlled by setting a threshold for determining the presence of a defect. The threshold may be the difference of the pixel compared to the reference image, e.g. compared to the equivalent pixel of the reference image. The rate of false positives is further controlled by applying noise reduction to either or both of the reference image and the sample image. However, noise reduction increases the amount of processing required to detect defects.

An efficient and effective approach to reduce noise in the sample image is by applying a simple filter by convolution, e.g. a uniform filter (convolution with a uniform kernel). To reduce noise in the reference image multiple source images may be averaged. In some cases, e.g. where the reference image is obtained by simulation from design data (often in GDSII format), noise reduction on the reference image may be omitted.

The efficiency and effectiveness of noise reduction in the sample image may be optimized by suitable selection of the size of the (uniform) filter. The optimum size of the filter may depend on factors such as the size of features on the sample, the size of defect to be detected, the resolution of the charged particle assessment device, the amount of noise in the images and the desired compromise between sensitivity and selectivity. The size of the kernel used to implement the filter may be equal to a non-integer number of pixels. A width in the range of 1.1 to 5 pixels, desirably in the range of 1.4 to 3.8 pixels, for the kernel is suitable in a variety of use cases. The form of the uniform kernel is discussed further below.

A square uniform kernel 505 with a non-integer size (width) is depicted in **Fig. 5** Such a uniform kernel comprises a central region 505a of n x n values, all of which are 1, and a peripheral region 505b made up of a top row, a bottom row, a left column and a right column. All of the values of the peripheral region are f, where f < 1, except the corner values which are f². The effective size of the uniform kernel is equal to n + 2f pixels. Optionally, the uniform kernel may be normalized (i.e. all values divided by a constant so that the sum of all values is 1). Alternatively or in addition, the filtered sample image may be normalized or rescaled.

In some cases, e.g. the uniform kernel described above, a two-dimensional kernel can be decomposed into two one-dimensional convolutions in orthogonal directions which are applied sequentially. This can be advantageous because the number of operations to perform an n x n two-dimensional convolution scales with the square of n whereas the number of operations to perform two n one-dimensional convolutions scales linearly with n.

The kernel need not be square and may, for example, be rectangular or any other convenient shape. The filter function implemented by the kernel need not be the same shape and size as the kernel; a kernel that is larger than the filter function will include zero values. Desirably the filter is symmetrical but that is not essential. Simulations suggest that a kernel implementing a uniform filter provides good results but some deviation from a mathematically uniform filter is permissible. For example corner filters could have values f, which would slightly overweight those pixels but not significantly. Non-uniform filters, e.g. a Gaussian filter, may be conveniently implemented by convolution with a suitable kernel.

The reference image may be obtained by averaging source images to obtain a reference image, and the averaging process may depend on the nature of the source images. Where the source images derive from a library of past scans, a large number of (e.g. more than 20, more than 30 or about 35) images may be averaged to obtain the reference image since the averaging can be performed off-line. The source images may be aligned before averaging.

Alternatively, the sample image may be compared to a reference image derived from "live" source images obtained from different parts of the same sample. In this case fewer, e.g. two, source images may be averaged to obtain the reference image. The two source images may be obtained from corresponding regions of different dies of the sample. Alternatively, if the pattern being inspected has a repeating element, the source images may be obtained from the same die. In some cases the source images may be shifted portions of the sample images. In cases where the sample image is compared to a reference image derived from live source images, the roles of the different images may rotate. For example if three images A, B and C are output by a charged particle assessment device: A and B may be averaged to provide a reference image to compare to C; A and C may be averaged to provide a reference image to compare to B; while B and C are averaged to provide a reference image to compare to A.

Another possibility is that the reference image is obtained from one or more "known-good" patterns. Another possibility is that the reference image is obtained by simulation, e.g. based on pattern or design data (e.g. in GDSII format). Such a reference image, at least by a first processing module e.g., in a first step of a two-step process, may be a simplification of the one or more "known-good" patterns or the simulation.

The result of the comparison of a sample image to a reference image may be a simple binary value representing a difference or a correspondence (i.e. matching) between the sample and references images. More desirably, the result of the comparison is a difference value representing the magnitude of the difference between the sample image and the reference image. Desirably, the result of the comparison is a difference value for each pixel (or each group of adjacent pixels which may be referred to a 'region of pixels') so that locations of defects within a source image can be determined greater precision.

To determine if a difference of a pixel or a region of pixels between source image and reference image represents a defect in the pattern being inspected, a threshold may be applied to the difference value corresponding to the pixel or region of pixels. The threshold may be fixed in advance, e.g. for a specific charged particle beam system or for a specific pattern to be inspected. The threshold may be a user-set parameter or by other conditions, for example it is updated from time to time dependent on application or from assessment. The threshold may be determined dynamically, updated during the course of processing, or both. Alternatively, a predetermined number of locations having the highest difference values may be selected as candidate defects for further inspection. Adjacent pixels having difference values higher than a threshold may be considered a single defect or candidate defect. All pixels of a single defect may be ascribed the same difference value. Such adjacent pixels and all pixels of a single defect may be referred to as a region of pixels.

An efficient approach to identifying a predetermined number of locations having the highest difference values is to process pixels in sequence and write pixel information and difference values to a buffer. Pixel information may include a region of pixel data surrounding a pixel or group of pixels identified as a potential defect. Such a region of pixel data may be referred to as a clip. If the buffer is full and a newly processed pixel has a higher difference value than the pixel in the buffer with the lowest difference value, the pixel information relating to the pixel with the lowest difference value is overwritten. In one possible implementation, until the buffer is full, the threshold for selection of pixels is set at a predetermined level. When the buffer is full the threshold is updated to the lowest difference value of the pixels stored in the buffer and updated each time a pixel in the buffer is overwritten. In this way only one comparison need be performed.

Alternatively, the threshold can be maintained constant and initially selected pixels can be separately tested to see if they have a higher difference than a pixel in the buffer already. Such a method may select a predetermined proportion of pixels and a predetermined amount of data. Alternatively the threshold may be set to select pixels that exceed the threshold so that the selected pixels that are tested have a magnitude corresponding or exceeding the set threshold. In such a method the proportion of pixels is not predetermined; so the quantity of data selected is not predetermined. The proportion of pixels selected may depend on the set of data being processed. Since the number of selected pixels in such methods is much lower than the total number of pixels, further processing of the selected pixels can be performed asynchronously (e.g. by a different processor) from initial processing without reducing throughput.

The charged particle assessment apparatus 100 may have a high throughput and a high resolution, meaning that data may be output at a high rate. For example the charged particle assessment device may have thousands, even tens of thousands, of beams or more, with each beam having one or more detector portions outputting data points at a rate of kilo- or mega-Hertz. Therefore, the rate at which data can be transferred from the detector module(s) to an image analysis device such as data processing device 500 (whether incorporated with the charged particle assessment device in a charged particle assessment system or a stand-alone device) can limit the throughput of the charged particle assessment device or system even where optical fibers are used.

As depicted in **Fig. 4****,** data processing device 500 comprises a filter module 501 which receives and filters a sample image from a charged particle assessment device 40, a reference image generator 503 which generates a reference image based on source images, a comparator 502 (for example a comparison module) which compares the filtered sample image to the reference image and an output module 504 which processes and outputs the result of the comparison.

Filter module 501 applies a filter to the input data, as discussed further below. Filter module 501 is conveniently implemented by dedicated hardware, e.g. an FPGA or an ASIC. Such dedicated hardware can be more efficient and economic than programmed general purpose computing devices such as a standard or common type of CPU architecture. The processor may be less powerful than a CPU, but may have architecture suited to processing software for processing the detection signal data, i.e. the images and so be capable of processing the images in the same or less time than the CPU. Such detected processing architecture, despite having a processing capability lower than most contemporaneous CPUs may be as fast at processing the data because the more efficient data architecture of the dedicated processing architecture. A general purpose CPU may be advantageous in that it allows the filter to be changed easily.

The reference image generator 503 may be operable in one or more modes, each mode representing a different approach to generation of the reference image.

In a library mode, the reference image generator 503 averages a large number of source images obtained from previous scans of patterns nominally the same as the pattern currently being assessed. Such images may have been generated earlier in the same batch of samples, or from samples in previous batches. The library images may be derived from test samples or production samples. Before averaging the images are desirably aligned with one another. Averaging the source images to generate the reference image has the effect of reducing noise. Averaging the source images in this way also averages away any defects that might be visible in the source images.

In the case where the pattern being inspected is a repeating pattern it is possible to generate the reference image by averaging a plurality of shifted versions of a source image. Each version of the source image is shifted by integer multiples of the dimensions of the unit cell. If either or both dimensions of the unit cell are not equal to an integer number of pixels, the shift amount can be rounded to the nearest pixel or a fractional pixel shift can be effected by interpolation, for example linear or cubic interpolation, such as bicubic interpolation, or any other known interpolation technique. Another possibility is to shift by a multiple of the pitch of the repeating pattern such that the multiple is an integer number of pixels. In effect, multiple instances of the unit cell are extracted from the source image and averaged. This approach may be referred to as an example of array mode, more specifically of providing a reference image for an array mode.

In a die-to-die mode, a charged particle assessment device is used to generate a sample image and two reference images of similar surface features which may have a repeating pattern. In an arrangement the sample image and each of the two reference images are from different dies of the sample (for example so that similar portions of the surface of different dies may be compared). The sample image may be compared to each of the reference images to identify differences between each of the reference images. Such a difference may be considered as a candidate defect. Differences which are common to the comparison between the sample image and the different reference images are treated as a defect. Differences which are only present in one of the comparisons between the sample image and the different reference images are treated as being a defect in the reference image and not in the sample image. Such defects in the reference image are removed from a group of the candidate defects. An image aligner is provided to align the images before they are supplied to the reference image generator 503 and filter module 501 as appropriate. For example such aligning may align at least portions of the images, or different portions of the sample each other, with respect to a repeating period of the repeating pattern.

In an arrangement three columns of a multi-column charged particle assessment device are used to generate the sample image and the two reference images. This arrangement is particularly efficient where the spacing between columns is equal to the die size of the sample being inspected since the columns will then automatically scan corresponding pattern features simultaneously. Using such an arrangement is also faster than using a single column because the sample image and reference images may be acquired simultaneously. In case there is a difference between the column spacing and die size, such as due to variations in the surface position of features on the sample surface, a buffer may be employed to correct the timing of image input to the data processing device.

In a variant of die-to-die mode, the same beam (of the same column in the case of a multi-column system) is used to generate a sample image and two reference images. This has the advantage that column to column and beam to beam corrections are not required and the routing of data can be simplified. For example such a calibration is the relative position of a beam relative to the ideal beam position for that beam or even for each beam. Using the same beam avoids the calibration, e.g. assessment of the offset, between beams for the different scans that are compared. Using the same beam means that although the beam has an offset with respect to the ideal beam position, there is no positional offset to correct for when comparing data retrieved from the scans. However, the need for data buffering might be increased, for example in frequency, if not in quantity of data buffered before the start of the comparison of the data from different dies.

An alternative version of array mode using single column, e.g. of a single-column system, provides a sample image which is compared against a reference image derived from two shifted versions of itself as source images. A buffer may be used to provide the shifted images.

It should be noted that it is also possible to apply the uniform filter to the source images and/or the reference images, in particular where the reference image is derived from a small number of source images that are obtained concurrently with the source image.

With reference again to **Fig. 4**, comparator 502 may be any logic circuit capable of comparing two values, for example an XOR gate or a subtractor. Comparator 502 is also suitable for implementation by dedicated hardware, e.g. an FPGA or an ASIC. Such dedicated hardware can be more efficient and economic than programmed general purpose computing devices, e.g. CPUs. Desirably, comparator 502 is implemented on the same dedicated hardware as filter module 501.

In some cases, the reference image generator 503 can also be implemented in dedicated hardware, especially where the reference image generator operates only in a mode where the reference image is generated from a small number of, e.g. two, source images. In that case it is desirable that the reference image generator is implemented in the same dedicated hardware as the comparator and/or filter module. The mathematical operations to average pixels of source images and compare to a pixel of a sample image can, in suitable cases, be combined into a single logic circuit.

Output module 504 receives the results output by comparator 502 and prepares output to the user, other fab systems or for further processing within the inspection system. The output may be in any of several different forms. In a simplest option, the output may simply be an indication that the sample has or does not have a defect. However, since almost all samples will have at least one potential defect, more detailed information is desirable for example as a data set, such as an image (e.g. such as a data set renderable as an image). Therefore the output may comprise, for example, a map of defect locations (or a detection data map), a deviation image, a clip of pixel data (for example of the image and the reference image, or of the reference image), and/or information as to the severity of a possible defect represented by the magnitude of the difference between the sample image and the reference image, for example how the sample image deviates from the reference image.

Output module 504 may also filter the potential defects, e.g. by only outputting defect locations where the magnitude of the difference between the sample image and the reference is greater than a threshold or the density of pixels showing a difference is higher than a threshold. Another possibility is to output only a predetermined number of most serious defect sites, indicated by the magnitude of the difference. This may be effected by storing defect sites in a buffer 510 and, when the buffer is full, overwriting the lowest magnitude defect if a higher magnitude defect is detected.

Any suitable format for the output of defect information may be used, e.g. a list, data set, image or a map. Desirably, output module 504 may output clips, that is images of regions of the sample where potential defects have been detected. This allows the potential defect to be further examined to determine if the defect is real and serious enough to affect operation of the device formed on or present in the sample. The rest of the source image, i.e. those parts not saved as clips, may be discarded to save on data storage and transfer requirements. The data set may thus be a set of clips; the image may comprise the set of clips,

As mentioned above, a problem with conventional charged particle assessment systems or devices may be that the rate at which data can be transferred from the detector to the image analysis module is a limiting factor in the throughput of the charged particle assessment system. As discussed with reference to Figure 3, the need to pass signals through a vacuum chamber wall, e.g. using a vacuum feedthrough, can limit the available bandwidth to transmit signals from the detector module 240 to the data processing device 500. Especially where the system has a large number of beams, the data rate generated by the system is very large. The present invention proposes to address this problem by distributing, e.g. splitting. the de-noising processing between circuitry integrated in, or close to, the detector, e.g. in CMOS features of the detector array, and circuitry remote from the detector, e.g. in the data processing device 500 in such a fashion that the amount of data that has to be transferred from the detector, or other circuitry incorporated in the electron-optical system 41, to remote circuitry (e.g. outside the main chamber 10) is reduced.

To obtain a two-dimensional image of the sample, the (or each) probe beam is scanned across the surface of the sample in a two-dimensional raster pattern. This involves movement of the beam in two directions: a main scanning direction and a sub-scanning direction which have different orientations, e.g. are orthogonal. The main scanning direction may be referred to as the fast scan direction or a major scanning direction. For example the scan deflector may be controlled to actuate the primary beam (e.g. multi-beam) in the fast direction. The sub-scanning direction may be referred to as the slow scan direction or a minor scanning direction. For example the stage maybe controlled to actuate the sample relative to the path of the primary beam; the scan deflector may be controlled to actuate the path of the beam over the sample surface in the slow direction; or both the stage and the scan deflector are actuated to achieve scanning in the slow direction. The stage is preferred to be used only in the slow direction because its inertia due to its large mass, makes achieving the movement of scanning in the fast direction, e.g. acceleration, more challenging than alternatives such as a scan deflector.

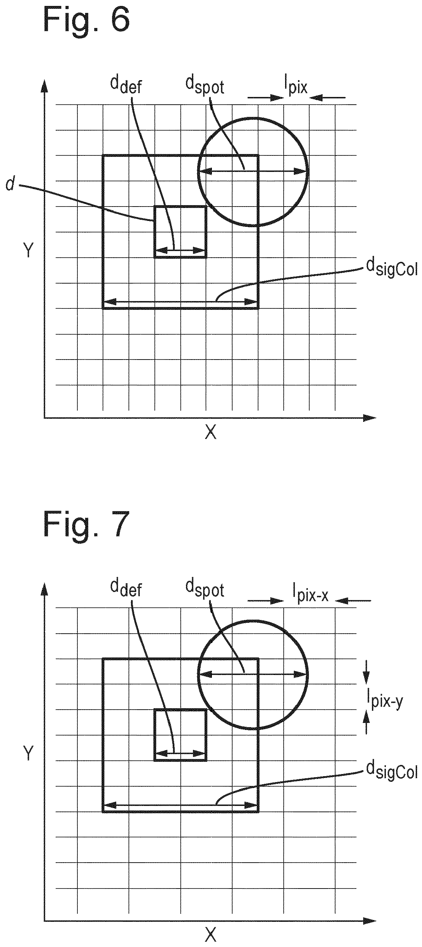

The signal from the detector is sampled at regular intervals such that the distance travelled in the main scanning direction between samples is equal to the distance between scan lines in the sub-scanning direction. The result is shown in **FIG. 6** which depicts a grid of square pixels overlaid on a sample having a defect *d.* The grid of square pixels has axes denoted by X and Y. The pixel size Iₚᵢₓ is chosen so that the expected size of a defect d_{def} in a direction of either of the two axes is two (2) pixels. The diameter of the probe spot dₛₚₒₜ is, in this example, four (4) pixels in a direction of either of the two axis. That is the dimensions of a square pixel is uniform or the same. So the dimension of the signal collection region d_{sigCol} influenced by the defect is six (6) pixels in a direction of either of the two axis. In an arrangement, the main scanning direction is the X direction and the sub-scanning direction is the Y direction.

The signal collection region d_{sigCol} corresponds to the size of a surface coverage of an expected defect on the sample for the defect to be detectable by the probe spot. It is the area of the sample surface when any part of the probe spot dₛₚₒₜ is located on a region of the sample surface corresponding to the expected size of a defect, i.e. the size of a pixel, d_{def};. The signal collection region also corresponds to a de-noising filter. In order to add up all the signals in the signal collection region, the pixel data is convoluted with a de-noising kernel. After applying the de-noising filter the sum of all the signals from the signal collection region will be present in the pixel proximate to the centre of the defect. The filter may be of any suitable type such as Gaussian, or a top hat (or a rectangular function) which appears of a circular shape or square shape (as depicted in **FIG. 6**). The filter may be uniform such as the top hat filter. The filter may be a kernel as described herein for noise reduction, so may be referred to as a de-noising filter. The filter may improve the signal to noise ratio. By convoluting the signal by applying the kernel the noise and detection signal are both reduced, but differently. The larger the filter, the greater the reduction. In balancing the signal to noise, the filter is selected so that the signal is reduced less than the noise. An optimum size of filter balances between the reduction in signal to noise when the size of the filter is close to, if not matches, the dimension of the desired feature. Such a filter may have dimensions of nanometers, which may correspond to a dimension size range of the defects. The filter size may be considered to be dependent on the dimensional size range of the defects expected and thus the application of the assessment.

In an embodiment, a de-noising filter in the main scanning direction is performed by circuitry integrated in or close to the detector module 240. An embodiment of the circuitry that performs the de-noising filter in the main scanning direction is a filter (or upstream filter or first filter) 402 as will be described later herein. The effect of the de-noising filter in the main scanning direction is to average the signal in the main scanning direction. The averaging of the signal in the main scanning direction allows for the sampling rate in the main scanning direction can be reduced, e.g. by a factor of two. This results, in effect, in a rectangular pixel. Such a rectangular pixel has dimension in different directions that are not uniform, different or dissimilar. The rectangular pixels are elongate, i.e. longer in one direction (the longitudinal direction) than in the perpendicular direction (the transverse direction). A grid of such rectangular pixels is depicted in **FIG. 7****.** In an embodiment, the rectangular pixels have dimensions Iₚᵢₓ₋ₓ e.g. a first dimension in a first direction and I_{pix-y} e.g. a second dimension in a second direction. The first dimension and second dimensions of the rectangular pixel are dissimilar; despite the term 'rectangular', the first and second dimensions (or first and second sides) of a rectangular pixel need not be orthogonal. The dimension Iₚᵢₓ₋ₓ is in the main scanning direction. The dimension I_{pix-y} is in the sub-scanning direction. In this example, the dimension Iₚᵢₓ₋ₓ (or main dimension) is twice the dimension I_{pix-y} (or sub-scanning dimension) in the sub-scanning direction. However, the main dimension is in the range of one to four times the sub-scanning dimension, for example 1.5 to 4 times the sub-scanning dimension. In a more desirable embodiment, the range is between 2 and 3, even equal to or greater than 2. In an example, the main scanning dimension Iₚᵢₓ₋ₓ is twice as large as the sub-scanning dimension I_{pix-y}.

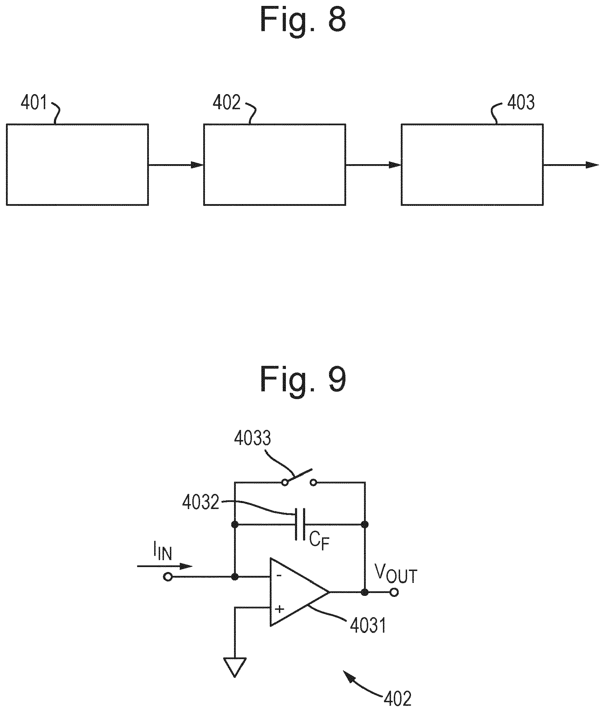

Circuitry to effect the above concept and that may be incorporated in the electron optical column, e.g. in a detector module 240, is depicted in **FIG. 8****.** A detector element 401 outputs an analog signal representing signal particles such as electrons received by the detector, e.g. secondary electrons emitted from the sample. Such signal particles are received by the detector as the probe beam is scanned across the sample in the main scanning direction. The analog signal is therefore a time-varying signal. In the time varying signal, the time axis corresponds to position on the sample in the main scanning direction and the amplitude axis corresponds to a property of the sample affecting its response to the probe beam. A de-noising filter 402 applies a de-noising filter to the analog signal in the analog domain to generate a filtered analog signal. The de-noising filter 402 desirably has time averaging characteristics, for example a uniform filter or a Gaussian filter with a predetermined time constant (e.g. window size) or a low-pass filter with a predetermined cut-off frequency. The denoising filter therefore has the effect of reducing stochastic and other high-frequency noise. An analog-to-digital converter 403 converts the filtered analog signal into a digital signal as data sets (e.g. images) and outputs the data sets. Here, the digital signal which is output in a data set comprises pixel values, e.g. as a series of pixel values, at a predetermined sampling rate.

Various parameters of the circuitry are selected to achieve a desired data rate and other effects, for example relative to the geometry of a rectangular pixel, including in terms of the dimensions of the rectangular pixel in the main scanning direction and the sub-scanning direction (i.e. the main scanning dimension and the sub-scanning dimension of a rectangular pixel). Specifically, the time constant or cut-off frequency of the de-noising filter 402 is set relative to the probe beam scanning speed in the main scanning direction to set an averaging length, which may be, for example, of the order of the expected defect size. The sampling rate of the analog-to-digital converter 403 is selected relative to the probe beam scanning speed in the main scanning direction to set an effective pixel dimension of the main scanning dimension Iₚᵢₓ₋ₓ in the main scanning direction.

The dimension of the rectangular pixel Iₚᵢₓ₋ₓ (or main dimension of the rectangular pixel) in the main scanning direction may for example have a size that is of the same order of magnitude of the defect size and/or about twice the pixel dimension in the sub-scanning direction (or sub-scanning dimension I_{pix-y}). The sub-scanning dimension I_{pix-y} may be equivalent to the spacing in the Y-direction (sub-scanning direction) between scanning lines. (Here a scanning line is the line along which the beam moves relative to the sample surface, for example over the sample surface, during scanning).

In some cases it is convenient if the pixel dimension Iₚᵢₓ₋ₓ in the main scanning direction (or main scanning dimension of a rectangular pixel) is an integer multiple of the sub-scanning dimension I_{pix-y} of the pixel (or the pixel dimension I_{pix-y} in the sub-scanning direction), i.e. the aspect ratio of the pixels is an integer. Desirably, the pixel dimension Iₚᵢₓ₋ₓ in the main scanning direction is greater than or equal to twice the pixel dimension I_{pix-y} in the sub-scanning direction; that is the aspect ratio of the pixels is greater than or equal to two (2). An aspect ratio of no more than three (3) has been found to be an effective compromise in various cases. All other things being equal, desirably the data rate that must be transmitted from the electron optical column is reduced by a factor equal to the aspect ratio of the pixels. Desirably, the length of the de-noising filter in the main scanning direction, is about the same as the length of the pixel in the main scanning direction. So the de-noising filter has a main scanning dimension in the main scanning direction that is similar or approximately the same as the sub-scanning dimension of the pixel. Thus data of the rectangular pixel is output from the denoising filter 402 with an effective filter size resulting from operation of the de-noising filter in the main scanning direction applied to the main scanning dimension of the pixel together with the filtering effect of the rectangular pixel in the sub-scanning direction.

**FIG. 9** depicts an embodiment of filter 402 that can be used in embodiments of the invention. Filter 402 comprises a trans impedance amplifier 4031 with a capacitive feedback 4032 as an example of an integrator. A switchable bypass 4033 allows the filtering effect to be turned off if not desired. A trans impedance amplifier with capacitive feedback as illustrated in **FIG. 9** acts as a uniform filter. A trans impedance amplifier having a low pass filter characteristic can also be used instead of a capacitive feedback. Such a low pass filter may be a trans impedance amplifier with resistive feedback or an electronic circuit with an RC low pass filter. This would have an effect similar to a Gaussian filter. The filter 402 outputs filtered data to the analog to digital converter 403. Such a filter may be incorporated into a sub-unit or detector element of a detector array or at any point in a datastream from the sub-unit to a processor remote from the detector array. Such a filter may be embodied in circuitry within the detector array as disclosed in WO 2022008462, which is hereby incorporated by reference so far as the inclusion of circuitry for example a trans-impedance amplifier for example with a sub-unit or detector element of a detector array.

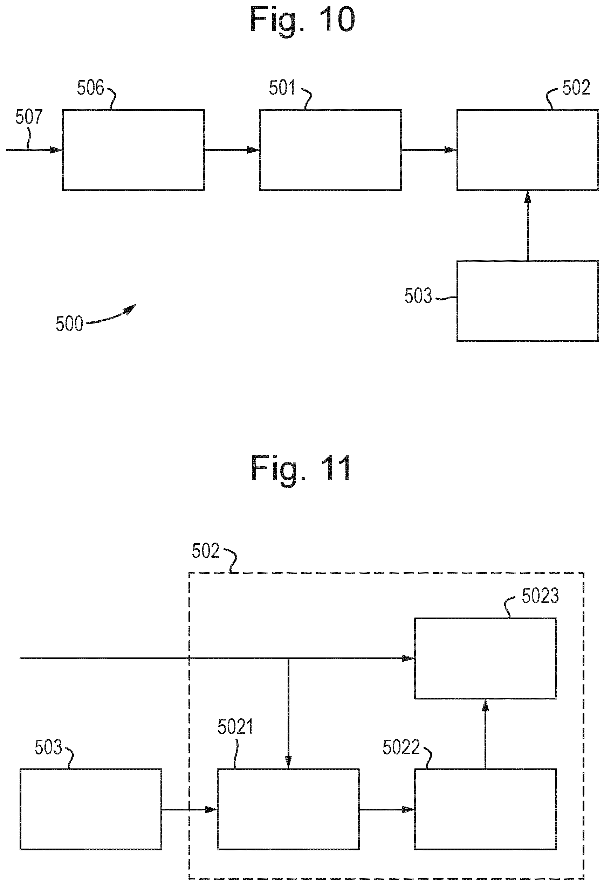

An image analysis device of an embodiment is depicted schematically in **FIG. 10****.** The image analysis device may form part of data processing device 500. In an embodiment the image analysis device is remote from a detector array, for example within a vacuum chamber. The image analysis device may part of an electron-optical assembly of the electron-optical column; such assembly may comprise the detector (such as detector array), and an objective lens (such as an objective lens array). The detector may be in a path of the beam grid and the image analysis device may be away from the path of the beam grid. The image analysis device may be separate from the detector, but electrically connected to the detector. In a different embodiment at least part of, if not all of, the image analysis device is remote from the electron optical column, such as remote from the electron-optical assembly, even external to a vacuum chamber comprising the electron-optical column. At least part of the image analysis device may be in signal communication with the detector through a feedthrough in a wall of the chamber.

The image analysis device is for further processing the digital signal from the analog to digital converter 403 which digital signal is based on the analog output from the de-noising filter 402. An interface module 506 receives via a communication channel 507 the pixel values, e.g. as a the series of pixel values, output by analog to digital converter 403, buffers the pixel values, e.g. in a random access memory, and outputs them in a desired order for subsequent processing. The communication channel may comprise optical fibers as described above or be any other suitable high-data rate channel or signal conduit. The communication channel may include parts in the detector, in the vacuum electronics, through the feedthrough, in the outside vacuum electronics close to the feedthrough and optical channels for example to the image analysis device.

A downstream filter module (or a second filter de-noising module) 501 is a de-noising filter, for example as a second de-noising filter. The downstream filter module 501 applies a de-noising filter in the sub-scanning direction, i.e. orthogonal to the main scanning direction. The de-noising filter in the sub-scanning direction may be a uniform filter or a Gaussian filter, for example. Desirably, the de-noising filter in the sub-scanning direction is the same type of filter as has been applied in the main scanning direction. However, in different arrangements at least a part the image analysis device is separate detector array, for example remote from the electron optical column (e.g. outside the vacuum chamber). Any communication channel passing through the wall of the chamber wall may take the form of a signal conduit such as an optical fiber.

The combination of the filtering in the main scanning direction performed in the circuity incorporated in the electron-optical column and the filtering in the sub-scanning direction performed in the remote image analysis device is equivalent to a two-dimensional noise filter as discussed above. By making the filter size (or dimension) of the de-noising filter in the sub-scanning direction the same as the effective filter size in the main scanning direction, an effective square filter is obtained. That is after filtering by the upstream filter and the downstream filter, the data values are the same as they would have been had they been filtered using a square filter in one step. That is, the resulting effective size of the filter size is approximately the same for both directions for example in the scale of defect being assessed, e.g. nanometers.

The comparator 502 compares the filtered signal output by de-noising filter 501 to a reference image provided by reference image generator 503 to detect defect candidates as described above.

Because of the use of non-square pixels (which may be rectangular), it may be desirable to store reference images to at a higher resolution than the sample images, for example for a die to database mode. The sample image may be aligned to the higher-resolution reference image. The higher-resolution reference image may then be down-sampled to the same resolution (and pixel shape) as the sample image. Down-sampling may be performed by various suitable techniques including averaging, pixel skipping, interpolation, etc. An arrangement to achieve this is shown in **FIG. 11****.**

As depicted in **FIG. 11****,** the comparator 502 comprises an alignment unit 5021. The alignment unit 5021 determines a shift between the sample image and the high-resolution reference image, e.g. by determining a pixel shift value that minimizes the difference between the sample image and the reference image, e.g.. between the sample reference data and the reference pixel data. The alignment may be considered to align the sample image (or the sample reference data) and the high-resolution reference image (or reference pixel data)). Since the sample image and the reference image are, or are approximately, the same size, the pixel shift value may be determined using just one or a small number of sub-regions of the respective images. The sub-regions may be predetermined or randomly selected. Based on the pixel shift value, a down-sampling unit 5022 generates a low resolution reference image for pixel-by-pixel comparison of at least the aligned portions with the sample image by comparator 502, e.g. by averaging aligned reference pixel data. (The low resolution reference may be down-sampled reference pixel data). In the case of a sub-pixel shift that is different from, (or not equal to) an integer number of pixels, the down-sampling unit may include an interpolation function for example as an interpolation unit. Additionally and/or alternatively, the alignment unit has an interpolation function, for example comprising an interpolating unit. Desirably, the down-sampling unit applies the same de-noising filter to the high-resolution reference image as is applied to the sample image. A sub pixel shift and a filter can be combined into a single processing step, e.g. convolution, to reduce computation steps. It should be noted that the aligning may comprise changing the aspect ratio of the reference pixel data and/or the sample image data. This may help ensure that the sample image (or sample image data) and the reference image (reference pixel data) are the same size. Additionally and/or alternatively the comparator may comprise a shift module. The shift module generates the reference pixel data by shifting the sample image data by a multiple of the pixel size thereof.

Note that aligning, for example in die-to-die mode, may align at least portions of the images or different portions of the sample image each other with respect to a repeating period of the repeating pattern. The repeating period may be equal to a whole number of pixels in the elongate direction or a whole number of pixels in a main scanning direction (or the reduced direction or lateral direction).

The use of a high resolution reference image is particularly advantageous where the reference image is derived from design data (e.g. GDSII data) by simulation for example in a die to database mode for inspection. High-resolution reference data can also be obtained (for example comprising reference pixel data) by scanning one or more (e.g. two or three) reference areas (e.g. dies) of the sample at a higher resolution (e.g. using square pixels) than the remainder of the sample. Such high-resolution scans can be performed on just some samples (e.g. one) of a batch of samples. Typically at least two reference images are used in the comparator with a sample image, for example in die-to-die mode, to reduce the risk of an apparent defect in the sample image being a defect in a reference image rather than in the sample image. However, reviewing a sample image using a single high-resolution scan may provide results with acceptable confidence so long as for example, the high resolution scan is of a sample surface known to have a low, even zero, likelihood of defects.

In an array mode, where the sample image is compared to a shifted version of itself, it is desirable that the shift amount is equal to both a whole number of pixels and an integer multiple of the unit cell size of the pattern being inspected, i.e. a common multiple of the pixel size and the unit cell size. Whilst it may be expected that increasing the pixel size reduces flexibility in the selection of the shift amount, the present invention enables a trade-off between optimum pixel size for noise reduction and shift amount that increases flexibility.

An advantage of the present invention is that a desired data rate for sample data transmitted from the detector to associated circuitry, to a remote image analysis device and/or to remote further processing of sample data sets or images can be provided by varying the pixel dimensions. The pixel dimension in the main scanning direction is determined by the sampling rate of the analog-to-digital converter and the scanning speed of the sample. The pixel dimension in the sub-scanning direction is determined by the step size of the sample shift between scan lines. Where the communication link between detector and remote image analysis device has a limited bandwidth, the pixel dimensions can be chosen to make optimum use of that bandwidth.

It is noted that reference to a pixel can be considered to be reference to a rectangular pixel unless specified otherwise. Whilst the above description mostly refers to rectangular pixels, it is emphasized that the pixels need not be rectangular and can have other shapes with an aspect ratio greater than 1 (i.e. one dimension larger than another). For example, if the scan directions are not orthogonal, it may be convenient to use pixels that represent areas that are parallelograms, with sides parallel to respective scanning directions. It will also be appreciated that the area in an output image represented by a pixel may not exactly correspond to an area of the sample from which signal electrons were sampled to give rise to that pixel, e.g. if the beam spot size is not the same as the spacing between scan lines.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electro-magnetic field of the compound lens array.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

An assessment tool or assessment system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array and objective lens array, under the control of the controller or control system or control unit. An actuatable component, such as a stage, may be controllable to actuate and thus move relative to another components such as the beam path using one or more controllers, control systems, or control units to control the actuation of the component.

The methods of the present invention may be performed by computer systems comprising one or more computers. A computer used to implement the invention may comprise one or more processors, including general purpose CPUs, graphical processing units (GPUs), Field Programmable Gate Arrays (FPGAs), Application Specific Integrated Circuits (ASICs) or other specialized processors. As discussed above, in some cases specific types of processor may provide advantages in terms of reduced cost and/or increased processing speed and the method of the invention may be adapted to the use of specific processor types. Certain steps of methods of the present invention involve parallel computations that are apt to be implemented on processers capable of parallel computation, for example GPUs.

A computer used to implement the invention may be physical or virtual. A computer used to implement the invention may be a server, a client or a workstation. Multiple computers used to implement the invention may be distributed and interconnected via a local area network (LAN) or wide area network (WAN). Results of a method of the invention may be displayed to a user or stored in any suitable storage medium. The present invention may be embodied in a non-transitory computer-readable storage medium storing instructions to carry out a method of the invention. The present invention may be embodied in computer system comprising one or more processors and memory or storage storing instructions to carry out a method of the invention.

Functionality provided by the computers and processors such as the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. Such computer programs may take the form of multiple computer programs that may be distributed for example implemented by different processors. The one or more computer programs may be provided in the form of media, optionally non-transitory media, storing computer readable instructions. When the computer readable instructions are read by the computer, the computer performs the required method steps. The computer may consist of a selfcontained unit or a distributed computing system having plural different computers connected to each other via a network.

The term "image" used herein is intended to refer to any data structure of values wherein each value relates to a sample of a location and the arrangement of values in the array corresponds to a spatial arrangement of the sampled locations. The term "data map" may be used to describe such a data structure. An image may comprise a single layer or multiple layers. In the case of a multi-layer image, each layer, which may also be referred to as a channel, represents a different sample of the locations. The term "pixel" is intended to refer to a single value of the array or, in the case of a multi-layer image, a group of values corresponding to a single location. An image may be stored in any convenient format in a computer-readable storage medium.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. A charged particle assessment apparatus for detecting defects in a sample by scanning a charged particle beam across the sample; the apparatus comprising: a detector unit configured to output a digital detection signal of pixel values in response to signal particles incident from the sample, the pixel values representing elongate pixels.
Clause 2. A charged particle assessment apparatus according to clause 1 wherein the detector unit comprises: a detector configured to generate an analog signal in response to charged particles incident thereon from the sample.
Clause 3. A charged particle assessment apparatus according to clause 2 wherein the detector unit further comprises: a filter configured to filter the analog signal to generate a filtered analog signal.
Clause 4. A charged particle assessment apparatus according to clause 3 wherein the filter comprises an integrator, optionally an amplifier, for example a trans-impedance amplifier, with a capacitive feedback.
Clause 5. A charged particle assessment apparatus according to clause 3 or 4 wherein the filter is a low-pass filter.
Clause 6. A charged particle assessment apparatus according to clause 3, 4 or 5 wherein the filter applies a uniform filter or a Gaussian filter.
Clause 7. A charged particle assessment apparatus according to any one of clauses 3 to 6 wherein the detector unit comprises: an analog to digital converter configured to convert the filtered analog signal into a series of the pixel values.
Clause 8. A charged particle assessment apparatus according to any one of the preceding clauses comprising: a charged particle device configured to direct a charged particle beam toward the sample; and a stage configured to support the sample, the charged particle device and the stage being configured to scan a surface of the sample with the charged particle beam.
Clause 9. A charged particle assessment apparatus according to clause 8 wherein the charged particle device and the stage are configured to perform a scan having a main scanning direction and a sub-scanning direction that has a different orientation from the main scanning direction.
Clause 10. A charged particle assessment apparatus according to clause 9 wherein the scan in the main scanning direction is faster over the surface of the sample than the sub-scanning direction.
Clause 11. A charged particle assessment apparatus according to clause 9 or 10 wherein the charged particle device is configured to scan the charged particle beam over the sample in at least the main scanning direction, optionally the main and sub-scanning directions.
Clause 12. A charged particle assessment apparatus according to clause 9, 10 or 11 wherein the stage is configured to move relative to the charged particle device to scan the charged particle beam over the sample in the sub-scanning direction.
Clause 13. A charged particle assessment apparatus according to any one of clauses 9 to 12 wherein the elongate pixels are elongate in the main scanning direction.
Clause 14. A charged particle assessment apparatus according to any one of the preceding clauses wherein the detector is an array of detector elements, desirably the charged particle beam is a plurality of charged particle sub-beams, each sub-beam associated with a detector element in the array of detector elements, and desirably the deflector is a deflector array, each sub-beam associated with a deflector element of the deflector array.
Clause 15. A charged particle assessment apparatus according to any one of the preceding clauses wherein the pixels have an aspect ratio between 1 and 4, desirably between 1.5 and 4, more desirably between 2 and 3, even equal to or greater than 2.
Clause 16. A charged particle assessment apparatus according to any one of the preceding clauses wherein the pixels have an integer aspect ratio.
Clause 17. A charged particle assessment apparatus according to any one of the preceding clauses having a plurality of charged particle devices, for example arranged in an array, configured to direct respective charged particle beams towards a sample.
Clause 18. A charged particle assessment apparatus according to any preceding clause, further comprising a controller configured to process the digital detection signal of pixel values.
Clause 19. An image analysis device comprising: an interface module configured to receive sample image data comprising pixel values representing an image of a sample obtained by a charged particle assessment device, wherein each pixel value represents a pixel that is elongate; and a downstream filter module configured to apply a de-noising filter to generate a filtered signal.
Clause 20. An image analysis device according to clause 19 wherein the de-noising filter is a uniform filter or a Gaussian filter.
Clause 21. An image analysis device according to clause 19 or 20 wherein the de-noising filter comprises a kernel extending in an additional direction different to the longitudinal direction of the elongate pixels, desirably orthogonal to the longitudinal direction.
Clause 22. An image analysis device according to clause 19, 20 or 21 further comprising a comparator configured to compare the filtered signal to reference data.
Clause 23. An image analysis device according to clause 22 wherein the reference data comprises reference pixel data that is higher resolution than the sample image data and the comparator comprises: an alignment unit configured to align the reference pixel data to the sample image data and generate aligned reference pixel data; and an down-sampling unit configured to average the aligned reference pixel data to generate a low resolution reference image having the same resolution as the sample image data.
Clause 24. An image analysis device according to clause 23 further comprising: a comparator configured to compare pixel data of the sample image data to corresponding down-sampled reference pixel data.
Clause 25. An image analysis device according to clause 23 or 24 wherein the down-sampling unit includes a second de-noising filter, e.g. a uniform filter or a Gaussian filter, to generate the down-sampled reference pixel data.
Clause 26. An image analysis device according to clause 23, 24 or 25 wherein the alignment unit comprises an interpolation unit configured: to shift the reference pixel data by an amount equal to or different from an integer multiple of the size of the pixels of the reference pixel data to generate the aligned reference pixel data; and/or to change the aspect ratio of the reference pixel data and/or the sample image data.
Clause 27. An image analysis device according to any one of clauses 23 to 26 wherein the reference pixel data is higher resolution than the sample image data in the longitudinal direction of the pixels.
Clause 28. An image analysis device according to any one of clauses 22 to 27 wherein the reference pixel data is derived from design data.
Clause 29. An image analysis device according to any of clauses 22 to 27 further comprising a shift module configured to generate the reference pixel data by shifting the sample image data by a multiple of the pixel size thereof.
Clause 30. An image analysis device according to any of clauses 22 to 29 wherein the reference data represents a reference image that is at least a portion of the size of the sample image data, desirably the portion of the reference image and the sample image data are of a repeating pattern, preferably the same repeating pattern.
Clause 31. A charged particle assessment system comprising: a charged particle assessment apparatus according to any one of clauses 1 to 18; an image analysis device according to any one of clauses 19 to 30; and a communication channel configured to communicate the series of pixel values from the charged particle assessment apparatus to the image analysis device.
Clause 32. A computer readable storage medium storing sample image data comprising pixel values representing an image of a sample obtained by a charged particle assessment system, wherein each pixel value represents a pixel that is elongate, desirably each pixel value having a contrast value representing a contrast in a contrast range, wherein the relative contrasts of adjacent elongate pixels exceed a contrast difference indicative of a defect, desirably the pixel values are configured to be renderable as pixels for example, in an image, arranged in a two dimensional array, desirably the two dimensional array is a grid, the pixels desirably having unequal dimensions, desirably being rectangular.
Clause 33. An image of a surface of a sample for detecting defects in the sample, the image comprising a plurality of elongate pixels each representing a portion of the sample surface and each having a different contrast, wherein the relative contrasts of the elongate pixels are indicative of a defect, desirably the elongate pixels arranged in a two dimensional array, desirably the two dimensional array is a grid, the elongate pixels desirably being having unequal dimensions, desirably being rectangular.
Clause 34. A method of data processing for an array mode using at least an image of a surface of a sample having a repeating pattern, the method comprising: generating at least one image of a surface of a sample having a repeating pattern, e.g. using a detector unit, the image having elongate pixels having an elongate direction and a reduced or lateral direction; and aligning at least portions of the at least one image with respect to a repeating period of the repeating pattern, to be equal to a whole number of pixels in the elongate direction or a whole number of pixels in the reduced or lateral direction; wherein the aligning comprises changing the aspect ratio of the pixels.
Clause 35. A method of data processing according to clause 35 further comprising comparing the pixels of the aligned portions.
Clause 36. A method of data processing according to clause 34 further comprising identifying pixels indicative of differences derived from comparing the pixels.
Clause 37. A method of data processing according to clause 36 further comprising identifying defects from the pixels identified as being indicative of differences.
Clause 38. A method of data processing according to any one of clauses 34 to 37 wherein the elongate pixels are rectangular pixels.
Clause 39. A method of data processing according to any one of clauses 34 to 38 wherein the elongate direction is a fast direction and/or a fast scan direction.
Clause 40. A method of data processing according to any one of clauses 34 to 39 further comprising combining the aligned reference pixel data to generate down-sampled reference pixel data having the same resolution as the at least one image.
Clause 41. A method of data processing for a die to database mode for comparing detection data with reference data, comprising: generating a detection data map of a sample surface, e.g. using a detector unit, the detection data having elongate detected pixels with a longitudinal direction and a lateral direction: shifting reference data to form a reference data map corresponding to the detection data map; and processing the reference data map comprising combining pixels of the reference data map in the longitudinal direction of the elongate detected pixels to derive a processed reference data map, the processed reference data map having the same size of pixel as the elongate detected pixels and the processed reference data map configured to have the same further processing applied as the detection data map.
Clause 42. A method of data processing according to clause 41 wherein shifting comprises shifting the reference data by an amount equal to or different from an integer multiple of the size of the pixels of the reference data.
Clause 43. A method of data processing according to clause 41 or 42 further comprising comparing the pixels of the detection data map and pixels of the reference data map.
Clause 44. A method of data processing according to clause 43 further comprising identifying pixels indicative of differences derived from comparing the pixels.
Clause 45. A method of data processing according to clause 44 further comprising identifying defects from the pixels identified as being indicative of differences.
Clause 46. A method of data processing according to any one of clauses 41 to 45 wherein the elongate pixels are rectangular pixels.
Clause 47. A method of data processing according to any one of clauses 41 to 46 wherein the elongate direction is a fast direction and/or a fast scan direction.
Clause 48. An image analysis method comprising: receiving sample image data comprising pixel values representing an image of a sample obtained by a charged particle assessment method, wherein each pixel value represents a pixel that is elongate; and applying a de-noising filter to generate a filtered signal.
Clause 49. An image analysis method according to clause 48 wherein the de-noising filter is a uniform filter or a Gaussian filter.
Clause 50. An image analysis method according to clause 48 or 49 wherein the de-noising filter comprises a kernel extending in an additional direction different to the longitudinal direction of the pixels, desirably orthogonal to the longitudinal direction.
Clause 51. An image analysis method according to clause 48, 49 or 50 further comprising comparing the filtered signal to reference data.
Clause 52. An image analysis method according to clause 51 wherein the reference data comprises reference pixel data that is higher resolution than the sample image data and the comparing comprises: aligning the reference pixel data to the sample image data and generate aligned reference pixel data; and down-sampling the aligned reference pixel data to generate down-sampling reference pixel data having the same resolution as the sample image data; and comparing pixel data of the sample image data to corresponding down-sampling reference pixel data.
Clause 53. An image analysis method according to clause 52 wherein the down-sampling includes applying a second de-noising filter, e.g. a uniform filter or a Gaussian filter, to generate the averaged reference pixel data.
Clause 54. An image analysis method according to clause 52 or 53 wherein the aligning comprises shifting the reference pixel data by an amount equal to or different from an integer multiple of the size of the pixels of the reference pixel data to generate the aligned reference pixel data.
Clause 55. An image analysis method according to clauses 52, 53, 54 wherein the aligning comprises changing the aspect ratio of the reference pixel data and/or the sample image data.
Clause 56. An image analysis method according to any one of clauses 52 to 55 wherein the reference pixel data is higher resolution than the sample image data in the longitudinal direction of the pixels.
Clause 57. An image analysis method according to any one of clauses 48 to 56 wherein the reference pixel data is derived from design data.
Clause 58. An image analysis method according to any of clauses 48 to 57 further comprising generating the reference pixel data by shifting the sample image data by a multiple of the pixel size thereof.
Clause 59. An image analysis method according to any of clauses 48 to 58 wherein the reference data represents a reference image that is at least a portion of the size of the sample image data, desirably the portion of the reference image and the sample image data are of a repeating pattern, preferably the same repeating pattern.
Clause 60. A detector unit for a charged particle assessment apparatus for detecting defects in samples by scanning a charged particle beam across a sample, the detector unit configured to output a digital detection signal of pixel values in response to signal particles incident from a sample, the pixel values representing elongate pixels.
Clause 61. A detector unit according to clause 60 further comprising: a detector element configured to generate an analog signal in response to incident charged particles; and a filter configured to filter the analog signal to generate a filtered analog signal.
Clause 62. A detector unit according to clause 61 wherein the filter comprises an integrator, optionally an amplifier, for example a trans-impedance amplifier, with a capacitive feedback.
Clause 63. A detector unit according to clause 61 or 62 wherein the filter is a low-pass filter.
Clause 64. A detector unit according to clause 61, 62 or 63 wherein the filter applies a uniform filter or a Gaussian filter.
Clause 65. A detector unit according to any one of clauses 61 to 64 further comprising: an analog to digital converter configured to convert the filtered analog signal into a series of the pixel values.
Clause 66. A detector unit for a charged particle assessment apparatus for detecting defects in samples by scanning a charged particle beam across a sample and outputting a detection signal of pixel values representing elongate pixels, the detector unit comprising a detector element to generate a detector signal in response to incident charged particles; and an integrator configured to filter the detector signal to generate an integrated detection signal, wherein the integrator is configured to filter the detector signal in an elongate direction corresponding to an elongate dimension of the pixel.
Clause 67. A detector unit according to clause 66 wherein the integrator comprises an amplifier, for example a trans-impedance amplifier, with capacitive feedback.
Clause 68. A detector unit according to clause 66 or 67 further comprising: an analog to digital converter configured to convert the integrated detection signal into a series of the pixel values.
Clause 69. A detector unit for a charged particle assessment apparatus for detecting defects in samples by scanning a charged particle beam across a sample, the detector unit configured to output a digital detection signal of pixel values in response to signal particles incident from a sample, the detector unit, comprising: a detector element configured to generate a detector signal in response to incident charged particles; and a trans-impedance amplifier with a capacitive feedback configured to amplify the detector signal.
Clause 70. A detector unit according to clause 69 further comprising: an analog to digital converter configured to convert an analog signal output by the trans-impedance amplifier into a series of the pixel values.
Clause 71. A charged particle assessment apparatus for detecting defects in samples by scanning a charged particle beam across a sample; the apparatus comprising: the detector unit of any of clauses 60 to 70.
Clause 72. A charged particle assessment apparatus for detecting defects in samples by scanning a charged particle beam across a sample; the apparatus comprising: a charged particle device configured to direct a charged particle beam toward a sample; a detector unit configured to output a digital detection signal of pixel values in response to signal particles incident from the sample, the pixel values representing elongate pixels having a longitudinal direction and a transverse direction; and a stage configured to support a sample; wherein: the charged particle device and the stage are configured to scan a surface of the sample with the charged particle beam; the stage is configured to move in a sub-scanning direction when the surface of the sample is scanned with the charged particle beam, the sub-scanning direction corresponding to the transverse direction.
Clause 73. A charged particle assessment apparatus for detecting defects in samples by scanning a charged particle beam across a sample; the apparatus comprising: a charged particle device configured to direct a charged particle beam toward a sample, desirably the charged particle device comprising a deflector; a detector unit configured to output a digital detection signal of pixel values in response to signal particles incident from the sample, the pixel values representing elongate pixels having a longitudinal direction and a transverse direction; and a stage configured to support a sample, the charged particle device and the stage being configured to scan a surface of the sample with the charged particle beam; wherein: the charged particle device (desirably the deflector) is configured to direct the beam in a main scanning direction when the surface of the sample is scanned with the charged particle beam, the main scanning direction corresponding to the longitudinal direction, and/or in a sub-scanning direction corresponding to the transverse direction, desirably the main scanning direction has a different orientation from the sub-scanning direction.

## Claims

1. A charged particle assessment apparatus for detecting defects in a sample by scanning a charged particle beam across the sample; the apparatus comprising:
a detector unit configured to output a digital detection signal of pixel values in response to signal particles incident from the sample, the pixel values representing elongate pixels.

2. A charged particle assessment apparatus according to claim 1 wherein the detector unit comprises:
a detector configured to generate an analog signal in response to charged particles incident thereon from the sample.

3. A charged particle assessment apparatus according to claim 2 wherein the detector unit further comprises:
a filter configured to filter the analog signal to generate a filtered analog signal.

4. A charged particle assessment apparatus according to claim 3 wherein the filter comprises an integrator, optionally an amplifier, for example a trans-impedance amplifier, with a capacitive feedback.

5. A charged particle assessment apparatus according to claim 3 or 4 wherein the filter is a low-pass filter; and/or wherein the filter applies a uniform filter or a Gaussian filter.

6. A charged particle assessment apparatus according to any one of claims 3 to 5 wherein the detector unit comprises:
an analog to digital converter configured to convert the filtered analog signal into a series of the pixel values.

7. A charged particle assessment apparatus according to any one of the preceding claims comprising:
a charged particle device configured to direct a charged particle beam toward the sample; and
a stage configured to support the sample, the charged particle device and the stage being configured to scan a surface of the sample with the charged particle beam.

8. A charged particle assessment apparatus according to claim 7 wherein the charged particle device and the stage are configured to perform a scan having a main scanning direction and a sub-scanning direction that has a different orientation from the main scanning direction.

9. A charged particle assessment apparatus according to claim 8 wherein the scan in the main scanning direction is faster over the surface of the sample than the sub-scanning direction.

10. A charged particle assessment apparatus according to claim 8 or 9 wherein the charged particle device is configured to scan the charged particle beam over the sample in at least the main scanning direction, optionally the main and sub-scanning directions; and/or wherein the stage is configured to move relative to the charged particle device to scan the charged particle beam over the sample in the sub-scanning direction.

11. A charged particle assessment apparatus according to any one of claims 8 to 10 wherein the elongate pixels are elongate in the main scanning direction.

12. A charged particle assessment apparatus according to any one of the preceding claims wherein the detector is an array of detector elements, desirably the charged particle beam is a plurality of charged particle sub-beams, each sub-beam associated with a detector element in the array of detector elements, and desirably the deflector is a deflector array, each sub-beam associated with a deflector element of the deflector array.

13. A charged particle assessment apparatus according to any one of the preceding claims wherein the pixels have an aspect ratio between 1 and 4, desirably between 1.5 and 4, more desirably between 2 and 3, even equal to or greater than 2.

14. A charged particle assessment apparatus according to any one of the preceding claims having a plurality of charged particle devices, for example arranged in an array, configured to direct respective charged particle beams towards a sample.

15. A charged particle assessment apparatus according to any preceding claim, further comprising a controller configured to process the digital detection signal of pixel values.
